# EUROPÄISCHE PATENTSCHRIFT

(11) **EP 0 570 820 B1**
(45) Veröffentlichungstag und Bekanntmachung des Hinweises auf die Patenterteilung: **24.07.1996**
(21) Anmeldenummer: 93107688.9
(22) Anmeldetag: 11.05.1993
(51) Int. Cl.: G05F 3/26, H03K 17/04

(54) **Schaltbare Stromquellenschaltung und Verwendung einer solchen in einer Phasendetektoranordnung**
Switchable current source circuit and the use of such a circuit in a phase detector
Circuit source de courant commutable et l'utilisation d'un tel circuit dans un détecteur de phase

(30) Priorität: 20.05.1992 DE 4216712
(43) Veröffentlichungstag der Anmeldung: 24.11.1993
(73) Patentinhaber: SIEMENS AKTIENGESELLSCHAFT, 80333 München (DE)
(72) Erfinder: Donig, Günter, Dipl.-Ing., W-8012 Ottobrunn (DE)

(56) Entgegenhaltungen:
- EP-A- 0 060 336
- EP-A- 0 212 833
- EP-A- 0 226 721
- WO-A-91/18338
- DE-A- 3 405 936
- DE-A- 4 201 155
- US-A- 4 544 878

## Beschreibung

Die Erfindung betrifft eine schaltbare Stromquellenschaltung nach dem Oberbegriff des Patentanspruches 1 sowie die Verwendung einer solchen in einer Phasendetectoranordnung. Insbesondere in dem Datenbuch der Firma Siemens, "ICs for Radio Equipment 1989/90", Seiten 51 bis 72 ist der kommerziell erhältliche integrierte Schaltkreis mit der Bezeichnung TBB 206 sowie dessen Anwendung in einer PLL beschrieben. Der in diesem Schaltkreis verwendete Phasendetector hat eine Ausgangsstufe, bestehend aus zwei Stromquellenschaltungen, die Ströme mit unterschiedlichem Vorzeichen auf einen gemeinsamen, den Ausgang bildenden Schaltungsknoten liefern. Die hierbei verwendeten analog gesteuerten Stromquellen erreichen nach ihrem Ansteuern erst nach relativ langer Zeit von ca. 30 ns ihren gewünschten Ausgangsstrom. Durch dieses langsame Ansteigen der Ausgangsströme dieser Stromquellen wird auch die Breite der in solchen Anwendungen erforderlichen Anti-Backlash-Impulse relativ groß. Diese Anti-Backlash-Impulse führen dazu, daß im Ausgangsspektrum des Phasendetectors neben der gewünschten Ausgangsfrequenz eine große Zahl von Nebenlinien jeweils im Abstand einer Eingangsreferenzfrequenz des Phasendetectors auftreten. Sind diese Anti-Backlash-Impulse relativ breit, so ist der Leistungsgehalt dieser Nebenlinien relativ hoch, so daß bei Verwendung in einer Phasenregelschleife zum Einhalten eines vorgegebenen Verhältnisses zwischen Signalpegel und Rauschpegel ein aufwendiges Filter verwendet werden muß. Eine Aufgabe der vorliegenden Erfindung ist das Bereitstellen von Stromquellen, bei deren Verwendung in der Ausgangsstufe eines Phasendetectors diese Probleme in erheblich geringerem Maße auftreten.

Stromspiegelschaltungen per se sind unter anderem aus Tietze/Schenk, Halbleiterschaltungstechnik, 9. Auflage 1991 in den Kapiteln 4.6.3, von Seite 62 bis 64, insbesondere Abbildung 4.36 sowie in dem Kapitel 5.5 auf Seiten 94 bis 97, insbesondere in Abbildung 5.13 beschrieben. Solche Stromspiegelschaltungen haben eine Steuerstufe, der ein Steuerstrom eingeprägt wird und die in Abhängigkeit von dem eingeprägten Steuerstrom eine Steuerspannung bereitstellt. Außerdem haben solche Stromspiegelschaltungen eine Ausgangsstufe, die in Abhängigkeit von der Steuerspannung der Steuerstufe einen Ausgangsstrom bereitstellen. Der Begriff Stromspiegelschaltung steht hierbei dafür, daß der Ausgangsstrom proportional zum Eingangsstrom ist. Speziell in integrierten Schaltungen wird mit Hilfe eines Transistorflächenverhältnisses, wobei die wirksame Fläche eines die Ausgangsstufe bildenden Transistors um einen bestimmten Faktor größer ist als die wirksame Fläche eines die Steuerstufe bildenden Transistors, eine Stromübersetzung bewirkt.

Außerdem ist bekannt, daß die üblicherweise fest an einem Bezugspotential angeschlossene Ausgangsstufe über einen elektronischen Schalter an dieses Bezugspotential schaltbar ist. Ist dieser elektronische Schalter dann leitend geschaltet, so fließt der Konstantstrom am Stromausgang der Stromquelle, sperrt dieser elektronische Schalter, so fließt kein Strom am Stromausgang der Stromquelle. Werden solche schaltbaren Stromquellen eingeschaltet, so fällt die von der Steuerstufe bereitgestellte Steuerspannung im Einschaltzeitpunkt etwas ab, so daß nicht unmittelbar der gewünschte Konstantstrom am Ausgang der Stromquellenschaltung fließt.

Aufgabe der vorliegenden Erfindung ist es, eine schaltbare Stromquellenschaltung bereitzustellen, deren Einschaltverhalten bezüglich dieses Problemes verbessert ist.

Diese Aufgabe wird gelöst durch eine schaltbare Stromquellenschaltung mit den Merkmalen des Patentanspruches 1.

Günstige Ausgestaltungen sind Gegenstand der Unteransprüche 1 bis 11. Die Verwendung solcher schaltbarer Stromquellenschaltungen ist Gegenstand der Ansprüche 11 bis 13.

Vorteile sowie die Funktionsweise der Erfindung werden nachstehend anhand der in den Figuren gezeigten Ausführungsbeispiele näher erläutert.

Es zeigt:
- Figur 1: eine erfindungsgemäße schaltbare Stromquellenschaltung in n-Kanal-MOS-Schaltungstechnik sowie eine erfindungsgemäße Stromquellenschaltung in p-Kanal-MOS-Schaltungstechnik, die beide gemeinsam eine bipolare Stromquellenanordnung bilden.
- Figur 2: die Ausgangsstufe einer Phasendetector-Schaltungsanordnung unter Verwendung erfindungsgemäßer schaltbarer Stromquellen;
- Figur 3a und Figur 3b: eine günstige Ausgestaltungsform einer Kapazität in n-Kanal- und in p-Kanal-MOS-Technologie, wie sie in einer Anordnung nach Figur 1 verwendet werden kann.

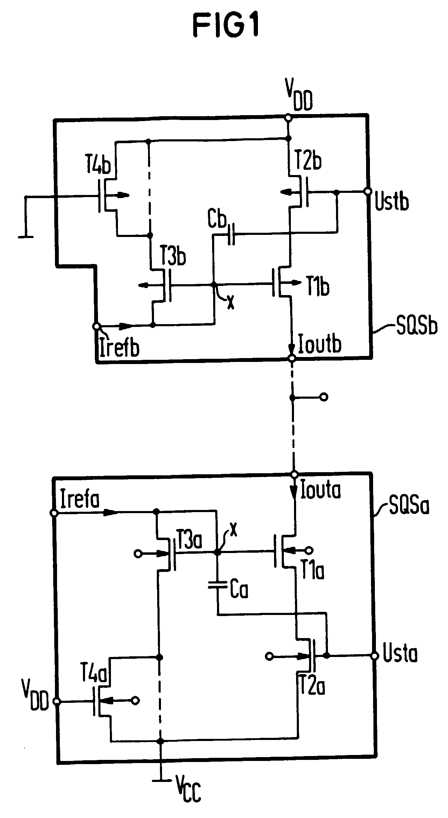

Figur 1 zeigt eine erfindungsgemäße Stromquellenschaltung SQSa in n-Kanal-MOS-Technik sowie eine erfindungsgemäße Stromquellenschaltung SQSb in p-Kanal-MOS-Schaltungstechnik. Hierbei haben gleiche Schaltungsteile gleiche Bezugszeichen, wobei in der n-Kanal-Schaltung den Bezugszeichen ein a zugefügt worden ist und in der p-Kanal-Schaltung ein b. Der Einfachheit halber wird nachfolgend nur die Schaltung in n-Kanal-Technik beschrieben. Dargestellt ist eine Stromspiegelschaltung, deren Steuerstufe durch einen Transistor T3a realisiert ist und deren Ausgangsstufe durch einen Transistor T1a realisiert ist. Hierzu ist der Drain-Anschluß des Transistors T3a mit seinem Basisanschluß zusammengeschaltet und bildet den Spannungsausgang x bzw. den Steuereingang x der Ausgangsstufe, der durch den Gate-Anschluß des Transistors T1a gebildet ist. Der Source-Anschluß des Transistors T3a ist mit der Versorgungspotentialklemme V_{CC} verbunden. Hierbei ist durch unterbrochene Linie dargestellt, daß diese Verbindung für die prinzipielle Funktionsweise der Schaltung unmittelbar vorgenommen werden sein kann.

Der Drain-Anschluß des Transistors T1a bildet den Stromausgang Iouta der Stromquellenschaltung SQSa, der Source-Anschluß des Transistors T1a ist mit dem Drain-Anschluß eines Transistors T2a verbunden. Der Transistor T2a ist als elektronischer Schalter vorgesehen und dient zum Ein- bzw. Ausschalten der Stromquellenschaltung SQSa. Hierzu ist der Source-Anschluß des Transistors T2a mit dem Versorgungspotentialanschluß V_{CC} verbunden und sein Gate-Anschluß ist als Steuereingang mit der Steuerspannungsklemme Usta zusammengeschaltet. Um die Proportionalität im Stromverstärkungsverhältnis sicherzustellen, kann der Source-Anschluß des Transistors T3a an dem Drain-Anschluß eines Transistors T4a zusammengeschaltet sein und nicht unmittelbar an Versorgungspotential geschaltet sein. In diesem Fall ist der Source-Anschluß des Transistors T4a mit der Versorgungspotentialklemme V_{CC} verbunden und sein Gate-Anschluß ist im einfachsten Falle mit dem Versorgungspotential der entgegengesetzten Polarität V_{DD} beaufschlagt. Der Transistor T4a sorgt im Steuer- bzw. Referenzpfad der Stromquellenschaltung für die gleichen Verhältnisse, wie sie im Ausgangspfad durch den Schalttransistor T2a bewirkt sind. Dadurch wird die Symmetrie der Stromspiegelschaltung sichergestellt.

Das Stromübersetzungsverhältnis zwischen dem Transistor T3 und dem Transistor T1 sollte gleich groß sein wie das zwischen dem Transistor T4 und dem des Transistors T2.

Bei einer Realisierung der dargestellten Schaltung in n-Kanal-Transistor-Technik kann durch Verbinden des Bulk-Anschlusses zusätzlich eine Substratsteuerung ausgeschlossen werden.

Erfindungsgemäß ist in Figur 1 zwischen dem Eingang der Steuerspannung Usta und dem Steuereingang x der Ausgangsstufe eine Kapazität Ca vorgesehen.

Wird der Transistor T2a durch eine Spannungsänderung am Steuereingang Usta eingeschaltet, so wird diese Spannungsänderung außerdem über die Kapazität Ca an den Steuereingang x der Ausgangsstufe T1a weitergeleitet. Hierbei werden zusätzliche Ladungen zu dem Steuereingang x der Ausgangsstufe geleitet.

Ein Einschalten des Transisstors T2a bewirkt bei der gegebenen Schaltung, daß eine in dem Transistor T1a enthaltene parasitäre Kapazität über den Gate-Anschluß dieses Transistors aufgeladen wird, bevor der Stromausgang Iouta den gewünschten Ausgangsstrom liefert. Die Kapazität Ca kann bedarfsweise in Abhängigkeit von dem an der Steuersignaleingangsklemme Usta angelegten Einschalt-Spannung so dimensioniert werden, daß im Einschaltmoment nahezu die gleiche Ladungsmenge über die Kapazität Ca zum Steuereingang x der Ausgangsstufe T1a geschaltet wird, wie zum Aufladen der Gate-Source-Kapazität des Transistors benötigt wird. Dadurch wird im Einschaltzeitpunkt ein Spannungseinbruch am Steuereingang der Ausgangsstufe der Stromquellenschaltung unterbunden.

Die Größe der Kapazität Ca ist in Abhängigkeit von der Stromdichte in der Stromspiegelschaltung zu wählen. Insbesondere muß sie so groß sein, daß durch ein Ansteigen der Steuerspannung am Gate-Anschluß des Transistors T2a sichergestellt ist, daß die Spannung am Gate-Anschluß des Transistors T1a im Einschaltzeitpunkt nicht absinkt. Wird die Kapazität Ca zu groß gewählt, so führt dies zu einer Überhöhung des Ausgangsstromes der Stromquelle im Einschaltzeitpunkt. Bei einer zu kleinen Kapazität Ca wird ein Absinken der Steuerspannung der Ausgangsstufe der Stromquellenanordnung nur verringert, aber nicht unterbunden.

In Figur 1 sind zwei schaltbare Stromquellenschaltungen SQSa und SQSb dargestellt, die an ihren Ausgängen Iouta und Ioutb Ströme mit unterschiedlichen Vorzeichen bereitstellen können. Die beiden Stromausgänge Iouta und Ioutb sind durch unterbrochene Linien dargestellt zu einem gemeinsamen Stromausgang zusammengefaßt, wodurch eine bipolare Stromquelle realisiert werden kann. Eine solche bipolare Stromquellenanordnung zeichnet sich dadurch aus, daß an ihrem Ausgang sowohl ein Strom mit positivem als auch ein Strom mit negativem Vorzeichen bereitgestellt werden kann. Wesentlich für den Ausgangsstrom dieser bipolaren Stromquelle ist die Differenz zwischen dem an der Klemme Ioutb bereitgestellten Strom und dem an der Klemme Iouta bereitgestellten Strom. Hierbei kann ggf. nur die eine Stromquellenschaltung SQSb oder die andere Stromquellenschaltung SQSa mit Hilfe der entsprechenden Steuerspannung Ustb bzw. Usta eingeschaltet sein, es können jedoch auch beide Spannungsquellen eingeschaltet sein, wobei durch unterschiedliche Referenzströme an den Stromeingangsklemmen Irefb und Irefa ein Differenzstrom als Ausgangsstrom der bipolaren Stromquelle eingestellt werden kann.

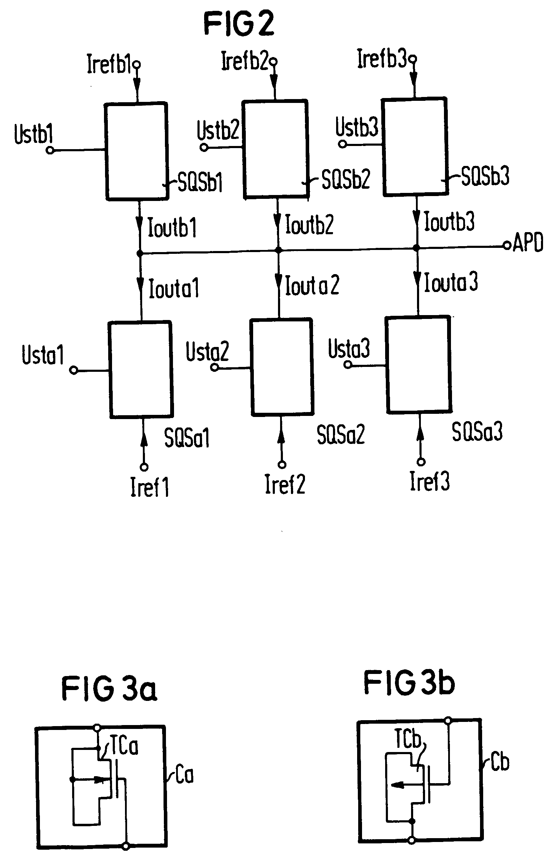

Figur 2 zeigt als Ausführungsbeispiel die Parallelschaltung von drei bipolaren Stromquellen nach Figur 1 als Ausgangsstufe einer Phasendetectoranordnung mit der Ausgangsklemme APD. Hierbei werden günstigerweise die Steuerspannungsklemmen Usta1, Usta2 und Usta3 bzw. die Steuerspannungsklemmen Ustb1, Ustb2 und Ustb3 zusammengeschaltet und von dem Phasendetector abhängig von der Phasendifferenz zweier Eingangssignale gesteuert. Die Referenzstromeingangsklemmen Irefa1, Irefa2, Irefa3, Irefb1, Irefb2 und Irefb3, können zur Variation der Amplitude des Ausgangsstromes an der Ausgangsklemme APD der Phasendetectoranordnung mit unterschiedlichen Referenzströmen angesteuert werden. Insbesondere bei der Verwendung einer solchen Phasendetectoranordnung in einer Phasenregelschleife, in der Kanalsprünge, d.h. Frequenzänderungen, vorgenommen werden, können diese Referenzströme an die jeweilige Betriebsfrequenz angepaßt sein.

Figur 3a zeigt eine mögliche Realisierungsform einer Kapazität Ca in Figur 1 durch eine Transistorschaltung TCa, wobei der Gate-Anschluß eines selbstsperrenden n-Kanal-FET einer Anschlußklemme der Kapazität bildet und der Source-Anschluß und der Drain-Anschluß sowie ggf., wie dargestellt, der Bulk-Anschluß gemeinsam die andere Anschlußklemme der Kapazität Ca bilden.

Figur 3b zeigt die Anordnung nach Figur 3a unter Verwendung eines p-Kanal-MOS-Feldeffektransistors, wie er als Kapazität Cb in Figur 1 verwendet werden könnte. Dieser Transistor TCb ist entsprechend geschaltet, wobei technologiebedingt der Bulk-Anschluß nicht als Kapazitätsanschluß verwendet ist.

Die Verwendung einer erfindungsgemäßen bipolaren Stromquellenanordnung in der Ausgangsstufe eines Phasendetectors hat den Vorteil, daß aufgrund des kurzfristigen Erreichens des Nennstromes durch die Ausgangsstufe die für Anti-Backlash-Impulse erforderliche Impulsbreite sehr klein werden kann. Dadurch ist die Rauschleistung der Nebenlinien im Ausgangsspektrum des Phasendetectors, die durch die Anti-Backlash-Impulse bedingt ist, erheblich geringer als bei der Verwendung von Stromquellenanordnungen nach dem Stande der Technik. Wird eine erfindungsgemäße Phasendetectoranordnung in einer Phasenregelschleife (PLL) eingesetzt, so kann mit einem sehr preiswerten Filter ein gewünschtes Signal-/Rauschleistungsverhältnis erreicht werden.

## Patentansprüche

1. Schaltbare Stromquellenschaltung mit einem elektronischen Schalter (T2a; T2b) und mit einer Stromspiegelanordnung (T1a, T3a, T4a; T1b, T3b, T4b), gebildet aus einer Steuerstufe (T3a, T4a; T3b, T4b), die abhängig von einem an einem Stromeingang (Irefa; Irefb) eingeprägten Steuerstrom an einem Spannungsausgang (x) eine Steuerspannung bereitstellt und aus einer Ausgangsstufe (T1a; T1b) mit einem Steuereingang, der mit dem Spannungsausgang (x) der Steuerstufe (T3a, T4a; T3b, T4b) verbunden ist und mit einer Steuerstrecke mit zwei Anschlüssen, von denen einer den Stromausgang (Iouta; Ioutb) der Stromquellenschaltung (SQSa; SQSb) bildet und der andere mit einem Anschluß des elektronischen Schalters (T2a; T2b) verbunden ist, wobei der andere Anschluß des elektronischen Schalters (T2a; T2b) mit einem Versorgungspotentialanschluß (V_{CC}; V_{DD}) verbunden ist und die Stromquellenschaltung abhängig von der Ansteuerung des Steuereinganges (Usta; Ustb) des elektronischen Schalters (T2a; T2b) ein- und ausschaltbar ist,
**dadurch gekennzeichnet,**
daß der Steuereingang des elektronischen Schalters (Usta; Ustb) und der Steuereingang (x) der Ausgangsstufe (T1a; T1b) der Stromspiegelanordnung über eine Kapazität (Ca; Cb) miteinander verbunden sind.

2. Stromquellenschaltung nach Anspruch 1,
**dadurch gekennzeichnet,**
daß als Transistoren und Schalter selbstsperrende n-Kanal-MOS-Transistoren verwendet werden.

3. Stromquellenschaltung nach Anspruch 1,
**dadurch gekennzeichnet,**
daß als Transistoren und Schalter selbstsperrende p-Kanal-MOS-Transistoren verwendet werden.

4. Stromquellenschaltung nach Anspruch 1,
**dadurch gekennzeichnet,**
daß als Transistoren und Schalter npn-Bipolartransistoren verwendet werden.

5. Stromquellenschaltung nach Anspruch 1,
**dadurch gekennzeichnet,**
daß als Transistoren und Schalter pnp-Bipolartransistoren verwendet werden.

6. Schaltbare Stromquellenschaltung nach einem der Ansprüche 2 oder 3,
**dadurch gekennzeichnet,**
daß die Steuerstufe aus einem Transistor (T3a; T3b) besteht, dessen Drain-Anschluß mit dem Gate-Anschluß zusammengeschaltet ist und gemeinsam mit diesem den Stromeingang (Irefa; Irefb) sowie den Spannungsausgang (x) der Steuerstufe bilden und dessen Source-Anschluß an einen Versorgungspotentialanschluß (V_{CC}; V_{DD}) geschaltet ist.

7. Stromquellenschaltung nach Anspruch 6,
**dadurch gekennzeichnet,**
daß der Source-Anschluß des die Steuerstufe bildenden Transistors (T3a; T3b) nicht unmittelbar, sondern über die Drain-Source-Strecke eines weiteren Transistors (T4a, T4b) an das besagte Versorgungspotential geschaltet ist, wobei der Gate-Anschluß dieses weiteren Transistors (T4a; T4b) mit einem Potential entgegengesetzter Polarität - z.B. dem anderen Versorgungspotential (V_{DD}; V_{CC}) - beaufschlagt ist.

8. Stromquellenschaltung nach einem der Ansprüche 2, 3, 6 oder 7,
**dadurch gekennzeichnet,**
daß die Ausgangsstufe aus einem Transistor (T2a; T2b) besteht, dessen Drain-Anschluß den Stromausgang (Iouta; Ioutb) der Stromquellenschaltung bildet und dessen Gateanschluß den Steuereingang (x) der Ausgangsstufe bildet und dessen Source-Anschluß mit dem Drain-Anschluß eines den elektronischen Schalter bildenden Transistors (T2a; T2b) zusammengeschaltet ist.

9. Stromquellenschaltung nach einem der Ansprüche 1, 2, 3, 6, 7 oder 8,
**dadurch gekennzeichnet,**
daß die Kapazität (Ca; Cb) durch einen Feldeffektransistor (TCa; TCb) realisiert ist, dessen Gate-Anschluß eine Anschlußklemme der Kapazität (Ca; Cb) bildet und dessen übrige Anschlüsse gemeinsam die andere Anschlußklemme der Kapazität (Ca; Cb) bilden.

10. Stromquellenschaltung nach Anspruch 9,
**dadurch gekennzeichnet,**
daß der Gate-Anschluß des die Kapazität (Ca; Cb) realisierenden Transistors (TCa; TCb) mit dem Steuereingang des elektronischen Schalters zusammengeschaltet ist.

11. Bipolare Stromquellenanordnung, bestehend aus zwei Stromquellenschaltungen (SQSa, SQSb) mit Ausgangsströmen unterschiedlichen Vorzeichens, deren Stromausgänge (Iouta, Ioutb) gemeinsam den Stromausgang der bipolaren Stromquellenanordnung bilden,
**dadurch gekennzeichnet,**
daß zur Realisierung der Anordnung mindestens zwei Stromqellenschaltungen (SQSa, SQSb) nach einem der vorhergehenden Ansprüche vorgesehen sind.

12. Verwendung einer bipolaren Stromquellenanordnung nach Anspruch 11 in der Ausgangsstufe eines Phasendetectors.

13. Verwendung einer bipolaren Stromquellenanordnung gemäß Anspruch 12,
**dadurch gekennzeichnet,**
daß mehrere Stromquellenschaltungen (SQSa1, SQSa2, SQSa3, SQSb1, SQSb2, SQSb3) vorgesehen sind, deren Ausgangsanschlüsse (Iouta1, Iouta2, Iouta3, Ioutb1, Ioutb2, Ioutb3) gemeinsam den Signalausgang (APD) des Phasendetectors bilden.

14. Verwendung einer bipolaren Stromquelle gemäß Anspruch 13,
**dadurch gekennzeichnet,**
daß die einzelnen Stromquellenschaltungen (SQSa1, SQSa2, SQSa3, SQSb1, SQSb2, SQSb3) unterschiedlich große Ausgangsströme an ihren Ausgängen (Iouta1, Iouta2, Iouta3, Ioutb1, Ioutb2, Ioutb3) bereitstellen, wobei jeweils zwei Stromquellen (Iouta1, Ioutb1; Iouta2, Ioutb2; ..) mit Ausgangsströmen unterschiedlichen Vorzeichens einen dem Betragen nach gleich großen Strom bereitstellen.

## Claims

1. Switchable current source circuit having an electronic switch (T2a; T2b) and having a current mirror arrangement (T1a, T3a, T4a; T1b, T3b, T4b), formed by a control stage (T3a, T4a; T3b, T4b), which provides a control voltage at a voltage output (x) as a function of a control current impressed at a current input (Irefa; Irefb), and by an output stage (T1a; T1b) having a control input, which is connected to the voltage output (x) of the control stage (T3a, T4a; T3b, T4b), and having a control path having two terminals, of which one forms the current output (Iouta; Ioutb) of the current source circuit (SQSa; SQSb) and the other is connected to a terminal of the electronic switch (T2a; T2b), the other terminal of the electronic switch (T2a; T2b) being connected to a supply potential terminal (V_{CC}; V_{DD}) and it being possible to switch the current source circuit on and off as a function of the driving of the control input (Usta; Ustb) of the electronic switch (T2a; T2b), characterized in that the control input of the electronic switch (Usta; Ustb) and the control input (x) of the output stage (T1a; T1b) of the current mirror arrangement are connected to one another via a capacitor (Ca; Cb).

2. Current source circuit according to Claim 1, characterized in that normally off n-channel MOS transistors are used as the transistors and switch.

3. Current source circuit according to Claim 1, characterized in that normally off p-channel MOS transistors are used as the transistors and switch.

4. Current source circuit according to Claim 1, characterized in that npn bipolar transistors are used as the transistors and switch.

5. Current source circuit according to Claim 1, characterized in that pnp bipolar transistors are used as the transistors and switch.

6. Switchable current source circuit according to either of Claims 2 and 3, characterized in that the control stage comprises a transistor (T3a; T3b), the drain terminal and the gate terminal of which transistor (T3a; T3b) are interconnected and jointly form the current input (Irefa; Irefb) as well as the voltage output (x) of the control stage, and the source terminal of which transistor (T3a; T3b) is connected to a supply potential terminal (V_{CC}; V_{DD}).

7. Current source circuit according to Claim 6, characterized in that the source terminal of the transistor (T3a; T3b) which forms the control stage is not connected directly to the said supply potential, but rather via the drain-source path of a further transistor (T4a, T4b), a potential of opposite polarity - for example the other supply potential (V_{DD}; V_{CC}) - being applied to the gate terminal of this further transistor (T4a; T4b).

8. Current source circuit according to any of Claims 2, 3, 6 and 7, characterized in that the output stage comprises a transistor (T1a, T1b), the drain terminal of which transistor (T1a; T1b) forms the current output (Iouta; Ioutb) of the current source circuit, and the gate terminal of which transistor (T1a; T1b) forms the control input (x) of the output stage, and the source terminal of which transistor (T1a; T1b) is interconnected with the drain terminal of a transistor (T2a; T2b) which forms the electronic switch.

9. Current source circuit according to any of Claims 1, 2, 3, 6, 7 and 8, characterized in that the capacitor (Ca; Cb) is realized by a field-effect transistor (TCa; TCb), the gate terminal of which transistor (TCa; TCb) forms one terminal of the capacitor (Ca; Cb) and the remaining terminals of which transistor (TCa; TCb) jointly form the other terminal of the capacitor (Ca; Cb).

10. Current source circuit according to Claim 9, characterized in that the gate terminal of the transistor (TCa; TCb) which realizes the capacitor (Ca; Cb) is interconnected with the control input of the electronic switch.

11. Bipolar current source arrangement, comprising two current source circuits (SQSa, SQSb) having output currents of different signs, the current outputs (Iouta, Ioutb) of which current source circuits jointly form the current output of the bipolar current source arrangement, characterized in that at least two current source circuits (SQSa, SQSb) according to one of the preceding claims are provided in order to realize the arrangement.

12. Use of a bipolar current source arrangement according to Claim 11 in the output stage of a phase detector.

13. Use of a bipolar current source arrangement according to Claim 12, characterized in that a plurality of current source circuits (SQSa1, SQSa2, SQSA3, SQSb1, SQSb2, SQSb3) are provided, their output terminals (Ioutal, Iouta2, Iouta3, Ioutbl, Ioutb2, Ioutb3) jointly forming the signal output (APD) of the phase detector.

14. Use of a bipolar current source according to Claim 13, characterized in that the individual current source circuits (SQSa1, SQSa2, SQSa3, SQSb1, SQSb2, SQSb3) provide output currents of different magnitudes at their outputs (Ioutal, Iouta2, Iouta3, Ioutbl, Ioutb2, Ioutb3), two current sources (Ioutal, Ioutbl; Iouta2, Ioutb2; ..) having output currents of different signs in each case providing a current which is identical in terms of its magnitude.

## Revendications

1. Circuit de source de courant pouvant être interrompu, comportant un interrupteur électronique (T2a ; T2b) et un dispositif (T1a, T3a, T4a ; T1b, T3b, T4b) de miroir de courant formé d'un étage (T3a, T4a ; T3b, T4b) de commande, lequel tient prête une tension de commande à une sortie (x) de tension en fonction d'un courant de commande imposé à une entrée (Irefa ; Irefb) de courant, et d'un étage (T1a ; T1b) de sortie comportant une entrée de commande, laquelle est reliée à la sortie (x) de tension de l'étage (T3a, T4a ; T3b, T4b) de commande, et comportant une section de commande comportant deux bornes, dont l'une forme la sortie (Iouta ; Ioutb) de courant du circuit (SQSa ; SQSb) de source de courant et l'autre est reliée à une borne de l'interrupteur électronique (T2a ; T2b), l'autre borne de l'interrupteur électronique (T2a ; T2b) étant reliée à une borne (V_{CC} ; V_{DD}) de potentiel d'alimentation et le circuit de source de courant pouvant être branché et débranché en fonction de la commande de l'entrée (Usta ; Ustb) de commande de l'interrupteur électronique (T2a ; T2b),
caractérisé en ce que
l'entrée de commande de l'interrupteur électronique (Usta ; Ustb) et l'entrée (x) de commande de l'étage (T1a ; T1b) de sortie du dispositif de miroir de courant sont reliées l'une à l'autre par l'intermédiaire d'une capacité (Ca ; Cb).

2. Circuit de source de courant suivant la revendication 1,
caractérisé en ce que
il est utilisé comme transistors et interrupteurs des transistors MOS à canal n et à blocage automatique.

3. Circuit de source de courant suivant la revendication 1,
caractérisé en ce que
il est utilisé comme transistors et interrupteurs des transistors MOS à canal p et à blocage automatique.

4. Circuit de source de courant suivant la revendication 1,
caractérisé en ce que
il est utilisé comme transistors et interrupteurs des transistors bipolaires npn.

5. Circuit de source de courant suivant la revendication 1,
caractérisé en ce que
il est utilisé comme transistors et interrupteurs des transistors bipolaires pnp.

6. Circuit de source de courant pouvant être interrompu suivant l'une des revendications 2 ou 3,
caractérisé en ce que
l'étage de commande est constitué d'un transistor (T3a ; T3b), dont la borne de drain est connectée à la borne de grille et forme conjointement avec cette borne l'entrée (Irefa ; Irefb) de courant ainsi que la sortie (x) de tension de l'étage de commande et dont la borne de source est branchée à une borne (V_{CC} ; V_{DD}) de potentiel d'alimentation.

7. Circuit de source de courant suivant la revendication 6,
caractérisé en ce que
la borne de source du transistor (T3a ; T3b) formant l'étage de commande n'est pas branchée directement mais par l'intermédiaire de la section drain-source d'un autre transistor (T4a, T4b) audit potentiel d'alimentation, la borne de grille de cet autre transistor (T4a ; T4b) recevant un potentiel de polarité opposée, par exemple l'autre potentiel (V_{DD} ; V_{CC}) d'alimentation.

8. Circuit de source de courant suivant l'une des revendications 2, 3, 6 ou 7,
caractérisé en ce que
l'étage de sortie est constitué d'un transistor (T2a ; T2b), dont la borne de drain forme la sortie (Iouta ; Ioutb) du circuit de source de courant, dont la borne de grille forme l'entrée (x) de commande de l'étage de sortie et dont la borne de source est connectée à la borne de drain d'un transistor (T2a ; T2b) formant l'interrupteur électronique.

9. Circuit de source de courant suivant l'une des revendications 1, 2, 3, 6, 7 ou 8,
caractérisé en ce que
la capacité (Ca ; Cb) est formée par un transistor (TCa ; TCb) à effet de champ, dont la borne de grille forme une borne de raccordement de la capacité (Ca ; Cb) et dont les autres bornes forment en commun l'autre borne de raccordement de la capacité (Ca ; Cb).

10. Circuit de source de courant suivant la revendication 9,
caractérisé en ce que
la borne de grille du transistor (TCa ; TCb) formant la capacité (Ca ; Cb) est connectée à l'entrée de commande de l'interrupteur électronique.

11. Dispositif bipolaire de source de courant, constitué de deux circuits (SQSa, SQSb) de source de courant à courant de sortie de signes différents, dont les sorties (Iouta ; Ioutb) de courant forment en commun la sortie de courant du dispositif bipolaire de source de courant,
caractérisé en ce que
il est prévu pour la réalisation du dispositif au moins deux circuits (SQSa ; SQSb) de source de courant suivant l'une des revendications précédentes.

12. Utilisation d'un dispositif bipolaire de source de courant suivant la revendication 11 dans l'étage de sortie d'un détecteur de phase.

13. Utilisation d'un dispositif bipolaire de source de courant suivant la revendication 12,
caractérisée en ce que
il est prévu plusieurs circuits (SQSa1, SQSa2, SQSa3, SQSb1, SQSb2, SQSb3) de source de courant, dont les bornes (Ioutal, Iouta2, Iouta3, Ioutbl, Ioutb2, Ioutb3) de sortie forment en commun la sortie (APD) de signal du détecteur de phase.

14. Utilisation d'une source bipolaire de courant suivant la revendication 13,
caractérisée en ce que
les divers circuits (SQSa1, SQSa2, SQSa3, SQSb1, SQSb2, SQSb3) fournissent des courants de sortie d'intensités différentes à leurs sorties (Ioutal, Iouta2, Iouta3, Ioutbl, Ioutb2, Ioutb3) , deux sources (Iouta1, Ioutb1 ; Iouta2, Ioutb2 ;...) de courant ayant des courants de sortie de signes différents fournissant des courants de valeurs absolues égales.
